# EUROPEAN PATENT APPLICATION

(11) **EP 4 593 554 A1**
(43) Date of publication of application: **30.07.2025**
(21) Application number: 25154443.3
(22) Date of filing: 28.01.2025
(51) Int. Cl.: H10D 89/60, H02H 9/04

(54) **INTEGRATED CIRCUIT AND ELECTRONIC DEVICE**

(30) Priority: 29.01.2024 CN 202410124014
(71) Applicant: Huawei Technologies Co., Ltd., Shenzhen, Guangdong 518129 (CN)
(72) Inventor: Li, Mingliang, Shenzhen,Guangdong, 518129 (CN)
(74) Representative: Grünecker Patent- und Rechtsanwälte PartG mbB

(57) **Abstract**

Embodiments of this application relate to the field of electronic technologies, and provide an integrated circuit and an electronic device, to implement an ESD protection circuit by using a low-voltage device, and improve reliability of each device in the ESD protection circuit. The integrated circuit includes a power line, a ground line, at least one ESD protection circuit, and a protected device. The protected device is disposed between the power line and the ground line. The ESD protection circuit includes a plurality of bias circuits that are coupled between the power line and the ground line and that are connected in series, a plurality of trigger circuits that are coupled between the power line and the ground line and that are connected in series, a plurality of MOS transistors that are coupled between the power line and the ground line and that are connected in series, and an ESD device coupled between the power line and the ground line. Output ends of the plurality of bias circuits each are coupled to an input end of each of the plurality of trigger circuits, and output ends of the plurality of trigger circuits are respectively coupled to control ends of the plurality of MOS transistors.

## Description

### TECHNICAL FIELD

This application relates to the field of electronic technologies, and in particular, to an integrated circuit and an electronic device.

### BACKGROUND

An integrated circuit (integrated circuit, IC) is also referred to as a chip (chip). Static electricity occurs in processes of manufacturing, transporting, packaging, and testing the chip, and electrostatic discharge (electrostatic discharge, ESD) may damage internal devices of the chip. Therefore, an ESD protection circuit for discharging an ESD current needs to be designed in the chip, so that the ESD current can be discharged through the ESD protection circuit when the ESD occurs in the chip, thereby protecting the internal devices of the chip.

In the conventional technology, the ESD protection circuit is implemented usually via a metal oxide semiconductor (metal oxide semiconductor, MOS) transistor. However, with evolution of a semiconductor process, the MOS transistor has gradually evolved from a high-voltage (for example, 5 V or 3.3 V) device to a low-voltage (for example, 1.8 V, 1.2 V, or 0.6 V) device, and a voltage provided by an external power module is usually a high voltage such as 5 V or 3.3 V Therefore, how to implement the ESD protection circuit of the integrated circuit via the low-voltage device is an urgent problem to be resolved.

### SUMMARY

This application provides an integrated circuit and an electronic device, to implement an ESD protection circuit of the integrated circuit by using a low-voltage device, and improve reliability of each device in the ESD protection circuit, thereby improving reliability of the ESD protection circuit, and ensuring a service life and performance of the integrated circuit.

To achieve the foregoing objectives, the following technical solutions are used in embodiments of this application.

According to a first aspect, an integrated circuit is provided. The integrated circuit includes a power line (or referred to as a power rail), a ground line (or referred to as a ground rail), at least one ESD protection circuit, and a protected device (for example, the protected device is a device corresponding to a functional module). The protected device is disposed between the power line and the ground line. The ESD protection circuit includes a plurality of bias circuits that are coupled between the power line and the ground line and that are connected in series, a plurality of trigger circuits that are coupled between the power line and the ground line and that are connected in series, a plurality of MOS transistors that are coupled between the power line and the ground line and that are connected in series, and an ESD device coupled between the power line and the ground line. Output ends of the plurality of bias circuits each are coupled to an input end of each of the plurality of trigger circuits, and output ends of the plurality of trigger circuits are respectively coupled to control ends of the plurality of MOS transistors. A withstand voltage of the ESD device, a sum of withstand voltages of the plurality of bias circuits, a sum of withstand voltages of the plurality of trigger circuits, and a sum of withstand voltages of the plurality of MOS transistors are all greater than or equal to a power voltage between the power line and the ground line. The plurality of bias circuits are configured to provide a plurality of different bias voltages. The plurality of trigger circuits are configured to provide a plurality of drive voltages based on the plurality of different bias voltages. The plurality of MOS transistors are configured to respectively receive the plurality of drive voltages. The ESD device is configured to discharge static electricity when the plurality of MOS transistors are turned on.

In the foregoing technical solution, when static electricity is generated in the integrated circuit, the ESD protection circuit may discharge the static electricity, to prevent the protected device in the integrated circuit from being affected by the static electricity. In addition, in the integrated circuit, the plurality of bias circuits, the plurality of trigger circuits, and the plurality of MOS transistors included in the ESD protection circuit are respectively connected in series and coupled between the power line and the ground line, and the sum of the withstand voltages of the plurality of bias circuits, the sum of the withstand voltages of the plurality of trigger circuits, and the sum of the withstand voltages of the plurality of MOS transistors are all greater than or equal to the power voltage between the power line and the ground line, so that a power voltage provided by the power line can be dispersedly borne by the plurality of bias circuits, the plurality of trigger circuits, and the plurality of MOS transistors. In this way, a voltage drop borne by each device in the plurality of bias circuits, the plurality of trigger circuits, and the plurality of MOS transistors is only a part of the power voltage. This ensures that voltage drops borne by each bias circuit, each trigger circuit, and each MOS transistor are respectively within ranges of the withstand voltages of each bias circuit, each trigger circuit, and each MOS transistor, and improves reliability of each device, thereby improving reliability of the ESD protection circuit, and ensuring a service life and performance of the integrated circuit.

In a possible implementation of the first aspect, each of the plurality of trigger circuits includes: a detection circuit, configured to detect an ESD current or an ESD voltage under an action of a bias voltage corresponding to the trigger circuit; and a drive circuit, configured to provide the drive voltage when the ESD current or the ESD voltage is detected. In the foregoing possible implementation, the detection circuit may detect the ESD current or the ESD voltage to detect an ESD event, and the drive circuit may be configured to provide the drive voltage for a MOS transistor when the ESD event occurs, so that the MOS transistor can be turned on, thereby discharging the static electricity.

In a possible implementation of the first aspect, the detection circuit includes a first resistor and a capacitor, the drive circuit includes an inverter, and a first end of the first resistor is coupled to a first node; a second end of the first resistor, a first end of the capacitor, and an input end of the inverter are coupled to each other; and a second end of the capacitor is coupled to a second node, the first node and the second node are two input ends of the trigger circuit, and an output end of the inverter is an output end of the trigger circuit. In the foregoing possible implementation, the first resistor, the capacitor, and the inverter can detect the ESD event, and when the ESD event occurs, the drive voltage is provided for the MOS transistor, so that the MOS transistor is turned on, thereby discharging the static electricity.

In a possible implementation of the first aspect, a first voltage end of an inverter of an N^{th} trigger circuit in the plurality of trigger circuits is coupled to the power line, a second voltage end of an inverter of a 1^{st} trigger circuit is coupled to the ground line, and a first voltage end of an inverter of an (i-1)^{th} trigger circuit is coupled to a second voltage end of an inverter of an i^{th} trigger circuit, where N is a quantity of the plurality of trigger circuits, and a value of i ranges from 2 to N. In the foregoing possible implementation, a manner of connecting in series and coupling the plurality of trigger circuits is provided. In the coupling manner, the power voltage provided by the power line can be dispersedly borne by the plurality of trigger circuits. In this way, a voltage drop borne by each of the plurality of trigger circuits is only a part of the power voltage. This ensures that a voltage drop borne by each trigger circuit is within a range of the withstand voltage of the trigger circuit, and improves reliability of each trigger circuit.

In a possible implementation of the first aspect, a first voltage end of an inverter of an N^{th} trigger circuit in the plurality of trigger circuits is coupled to the power line, and a second voltage end of an inverter of a 1^{st} trigger circuit is coupled to the ground line; and a first voltage end of an inverter of an (i-1)^{th} trigger circuit is coupled to an output end of an i^{th} trigger circuit, and a second voltage end of an inverter of the i^{th} trigger circuit is coupled to a second node of the i^{th} trigger circuit; or a second voltage end of an inverter of an i^{th} trigger circuit is coupled to an output end of an (i-1)^{th} trigger circuit, and a first voltage end of the inverter of the i^{th} trigger circuit is coupled to a second node of the i^{th} trigger circuit, where N is a quantity of the plurality of trigger circuits, and a value of i ranges from 2 to N. In the foregoing possible implementation, a manner of connecting in series and coupling the plurality of trigger circuits is provided. In the coupling manner, the power voltage provided by the power line can be dispersedly borne by the plurality of trigger circuits. In this way, a voltage drop borne by each of the plurality of trigger circuits is only a part of the power voltage. This ensures that a voltage drop borne by each trigger circuit is within a range of the withstand voltage of the trigger circuit, and improves reliability of each trigger circuit.

In a possible implementation of the first aspect, the plurality of MOS transistors include a plurality of NMOS transistors or a plurality of PMOS transistors; and/or the plurality of bias circuits include a plurality of second resistors; and/or the ESD device is a junction diode or a triode. In the foregoing possible implementation, diversity of the plurality of MOS transistors, the plurality of bias circuits, and the ESD device can be improved, and flexibility of selection during design can be improved.

In a possible implementation of the first aspect, the withstand voltage of the ESD device is N times the withstand voltage of the bias circuit, the withstand voltage of the trigger circuit, or the withstand voltage of the MOS transistor, where N is greater than 1. In the foregoing possible implementation, voltage drops borne by the bias circuit, the trigger circuit, the MOS transistor, and the ESD protection device in the ESD protection circuit can be respectively within ranges of the withstand voltages of the bias circuit, the trigger circuit, the MOS transistor, and the ESD device, thereby improving reliability of the devices, improving reliability of the ESD protection circuit, and ensuring a service life and performance of the integrated circuit.

According to a second aspect, an electronic device is provided. The electronic device includes a circuit board and the integrated circuit that is provided in any one of the first aspect or the possible implementations of the first aspect and that is disposed on the circuit board.

It may be understood that, for beneficial effects that can be achieved by the electronic device provided above, refer to the beneficial effects in the integrated circuit provided above. Details are not described herein again.

### BRIEF DESCRIPTION OF DRAWINGS

FIG. 1 is a diagram of a structure of an ESD protection circuit;
FIG. 2 is a diagram of a structure of an integrated circuit according to an embodiment of this application;
FIG. 3 is a distribution diagram of an ESD protection circuit in an integrated circuit according to an embodiment of this application;
FIG. 4 is a diagram of a structure of an ESD protection circuit according to an embodiment of this application;
FIG. 5 is a diagram of a structure of another ESD protection circuit according to an embodiment of this application;
FIG. 6 is a diagram of a structure of still another ESD protection circuit according to an embodiment of this application; and
FIG. 7 is a diagram of a structure of yet another ESD protection circuit according to an embodiment of this application.

### DESCRIPTION OF EMBODIMENTS

The making and use of embodiments are discussed in detail below. It should be understood that many applicable inventive concepts provided in this application may be implemented in a plurality of specific environments. The specific embodiments discussed are merely illustrative of specific ways to implement and use this application and this technology, and do not limit the scope of this application.

Unless otherwise defined, all technical terms used in this specification have the same meaning as those commonly known to a person of ordinary skill in the art.

The circuits or other components may be described as or referred to as "configured to" perform one or more tasks. In this case, the phrase "configured to" is used for implying a structure by indicating that a circuit/component includes a structure (for example, a circuit system) that performs one or more tasks during operation. Therefore, even when a specified circuit/component is currently not operable (for example, not opened), the circuit/component may also be referred to as being configured to perform the task. Circuits/components used in conjunction with the phrase "configured to" include hardware, for example, a circuit for performing an operation.

The following describes the technical solutions in embodiments of this application with reference to the accompanying drawings in embodiments of this application. In this application, "at least one" indicates one or more, "a plurality of" indicates two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may represent: a, b, c, a and b, a and c, b and c, or a, b, and c, where a, b, and c may be singular or plural.

In embodiments of this application, words such as "first" and "second" are used to distinguish between objects with similar names or functions or effects. A person skilled in the art may understand that the words such as "first" and "second" do not limit a quantity and an execution sequence. The term "coupling" is used for representing an electrical connection, including a direct connection through a wire or a connection end or an indirect connection through another device. Therefore, "coupling" should be considered as a generalized electronic communication connection.

It should be noted that, in this application, the word such as "example" or "for example" is used to represent giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

An integrated circuit (integrated circuit, IC) is also referred to as a chip (chip) and is vulnerable to damage caused by static electricity. Generally, a protection circuit is designed between a power line (or referred to as a power end) and a ground line (or referred to as a ground end) of the integrated circuit, to prevent an internal circuit (or referred to as a protected circuit) from being damaged by the static electricity. In the integrated circuit, an electrostatic discharge (electrostatic discharge, ESD) protection circuit is usually used for reducing the damage caused by the static electricity. The ESD protection circuit may be implemented by using a metal oxide semiconductor (metal oxide semiconductor, MOS) transistor. The MOS transistor may also be referred to as a MOS transistor.

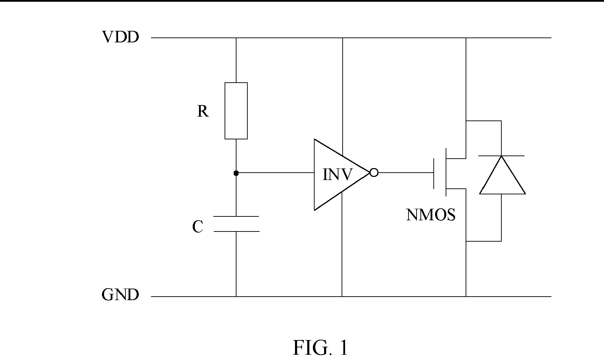

FIG. 1 is a diagram of a structure of an ESD protection circuit. The ESD protection circuit includes a detection circuit and an NMOS transistor. The detection circuit includes a resistor R, a capacitor C, and an inverter INV One end of the resistor R and one end of the capacitor C are both coupled to an input end of the inverter INV, the other end of the resistor R and the other end of the capacitor C are respectively coupled to a power line VDD and a ground line GND, an output end of the inverter INV is coupled to a control end of the NMOS transistor, two voltage ends of the inverter INV are respectively coupled to the power line VDD and the ground line GND, and a source end and a drain end of the NMOS transistor are respectively coupled to the power line VDD and the ground line GND.

In the ESD protection circuit, values of withstand voltages of the capacitor C, the inverter INV, and the NMOS transistor are all VDD. However, with evolution of a semiconductor process, a MOS transistor has gradually evolved from a high-voltage device to a low-voltage device. For example, a value of a withstand voltage of the MOS transistor evolves from original 5 V, 3.3 V, 2.5 V, or 1.8 V to 1.2 V, 0.6 V, or the like. A voltage (which may be represented as Vs) provided by an external power module such as a power management unit (power management unit, PMU) is usually a high voltage such as 5 V or 3.3 V. Consequently, when Vs is equal to two times VDD, three times VDD, or more times VDD, reliability problems may occur in the capacitor C, the inverter INV, and the NMOS transistor in the ESD protection circuit. As a result, the integrated circuit is aged or becomes invalid, and a service life requirement of a product cannot be met.

Based on this, embodiments of this application provide an integrated circuit and an ESD protection circuit. This ensures that a voltage drop borne by each device (for example, a bias circuit, a trigger circuit, and a MOS transistor that are mentioned below) in the ESD protection circuit is within a range of a withstand voltage of each device, and improves reliability of each device, thereby improving reliability of the ESD protection circuit, and ensuring a service life and performance of the integrated circuit.

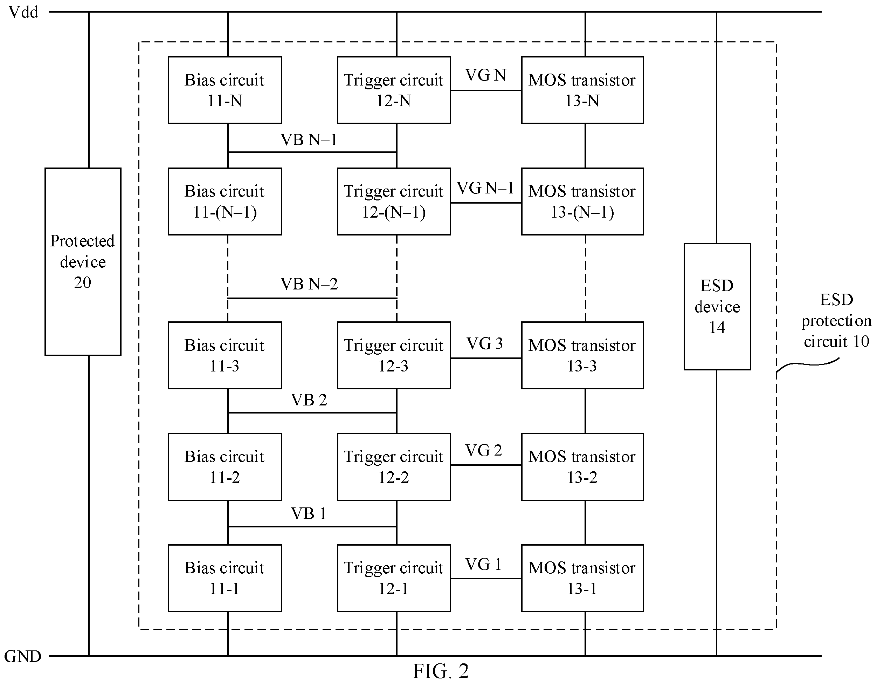

FIG. 2 is a diagram of a structure of an integrated circuit according to an embodiment of this application. The integrated circuit includes a power line Vdd, a ground line GND, at least one ESD protection circuit 10, and a protected device 20. The protected device 20 is disposed between the power line Vdd and the ground line GND. In FIG. 2, an example in which the integrated circuit includes one ESD protection circuit 10 is used for description. When the integrated circuit includes a plurality of ESD protection circuits 10, the plurality of ESD protection circuits 10 are connected in parallel between the power line Vdd and the ground line GND. The power line Vdd may also be referred to as a power rail, and the ground line GND may also be referred to as a ground rail. The protected device may be a device corresponding to a functional module. For example, the protected device may include a processor, a memory, and/or the like.

The ESD protection circuit 10 includes a plurality of bias circuits 11 that are coupled between the power line Vdd and the ground line GND and that are connected in series, a plurality of trigger circuits 12 that are coupled between the power line Vdd and the ground line GND and that are connected in series, a plurality of MOS transistors 13 that are coupled between the power line Vdd and the ground line GND and that are connected in series, and an ESD device 14 coupled between the power line Vdd and the ground line GND. Output ends of the plurality of bias circuits 11 are respectively coupled to input ends of the plurality of trigger circuits 12, and output ends of the plurality of trigger circuits 12 are respectively coupled to control ends (or referred to as gates) of the plurality of MOS transistors 13.

A withstand voltage of the ESD device 14, a sum of withstand voltages of the plurality of bias circuits 11, a sum of withstand voltages of the plurality of trigger circuits 12, and a sum of withstand voltages of the plurality of MOS transistors 13 are all greater than or equal to a power voltage between the power line Vdd and the ground line GND.

Optionally, the withstand voltage of the ESD device 14 is greater than the withstand voltage of the bias circuit 11, the withstand voltage of the trigger circuit 12, or the withstand voltage of the MOS transistor 13. In a possible example, the withstand voltage of the ESD device 14 is N times the withstand voltage of the bias circuit 11, the withstand voltage of the trigger circuit 12, or the withstand voltage of the MOS transistor 13, where N is greater than 1, and a value of N may be an integer or a non-integer. The following uses an example in which N is an integer for description. For example, the withstand voltage of the bias circuit 11, the withstand voltage of the trigger circuit 12, and the withstand voltage of the MOS transistor 13 are all VDD (or the withstand voltage of the bias circuit 11, the withstand voltage of the trigger circuit 12, and the withstand voltage of the MOS transistor 13 are different, and a minimum withstand voltage is VDD), the withstand voltage of the ESD device 14 is N×VDD, and a voltage between the power line Vdd and the ground line is N×VDD, where N may be 2, 3, 4, or the like.

In the ESD protection circuit, the plurality of bias circuits 11 are configured to provide a plurality of different bias voltages, the plurality of trigger circuits 12 are configured to provide a plurality of drive voltages based on the plurality of different bias voltages, the plurality of MOS transistors 13 are configured to respectively receive the plurality of drive voltages, the plurality of drive voltages may be used for turning on the plurality of MOS transistors 13, and the ESD device is configured to discharge static electricity in the integrated circuit when the plurality of MOS transistors 13 are turned on. In this way, when static electricity is generated in the integrated circuit, the ESD protection circuit may discharge the static electricity, to prevent the protected device 20 in the integrated circuit from being affected by the static electricity.

Optionally, a quantity of the plurality of bias circuits 11, a quantity of the plurality of trigger circuits, and a quantity of the plurality of MOS transistors 13 may be the same or different. In an example, if quantities of three types of the circuits are the same, one bias circuit 11 may be correspondingly coupled to one trigger circuit 12, or one trigger circuit 12 may be correspondingly coupled to one or more MOS transistors 13. In another example, if quantities of three types of the circuits are different, at least two bias circuits 11 may be correspondingly coupled to one trigger circuit 12, or at least two trigger circuits 12 may be correspondingly coupled to one MOS transistor 13, or at least two MOS transistors 13 may be correspondingly coupled to one trigger circuit 12. In FIG. 2, the quantity of the plurality of bias circuits 11, the quantity of the plurality of trigger circuits, and the quantity of the plurality of MOS transistors 13 are the same and are N. For example, the plurality of bias circuits 11 include bias circuits 11-1 to 11-N and the plurality of different bias voltages provided are a VB 1 to a VB N-1, the plurality of trigger circuits 12 include bias circuits 12-1 to 12-N and the plurality of drive voltages provided are a VG 1 to a VG N, and the plurality of MOS transistors 13 include MOS transistors 13-1 to 13-N.

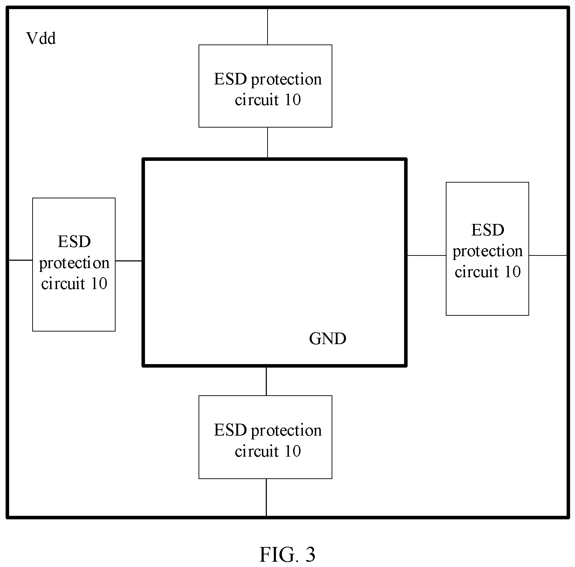

Further, as shown in FIG. 3, the at least one ESD protection circuit 10 may include a plurality of ESD protection circuits 10, and the plurality of ESD protection circuits 10 may be evenly disposed between the power line Vdd and the ground line GND, to form an ESD protection network to protect the integrated circuit from damage caused by the static electricity. FIG. 3 does not show the protected device 20 in the integrated circuit and a specific structure of each ESD protection circuit 10.

Further, each of the plurality of trigger circuits 12 may include a detection circuit and a drive circuit. The detection circuit is configured to detect an ESD current or an ESD voltage under an action of a bias voltage received by the trigger circuit 12. The drive circuit is configured to provide the drive voltage when the ESD current or the ESD voltage is detected. In other words, in the trigger circuit 12, the detection circuit is configured to detect an ESD event, and the drive circuit is configured to provide the drive voltage when the ESD event occurs.

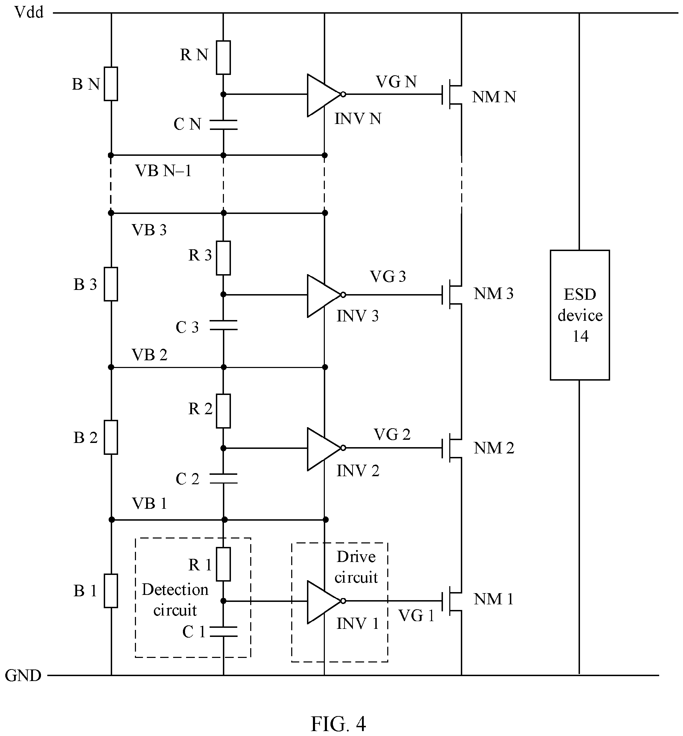

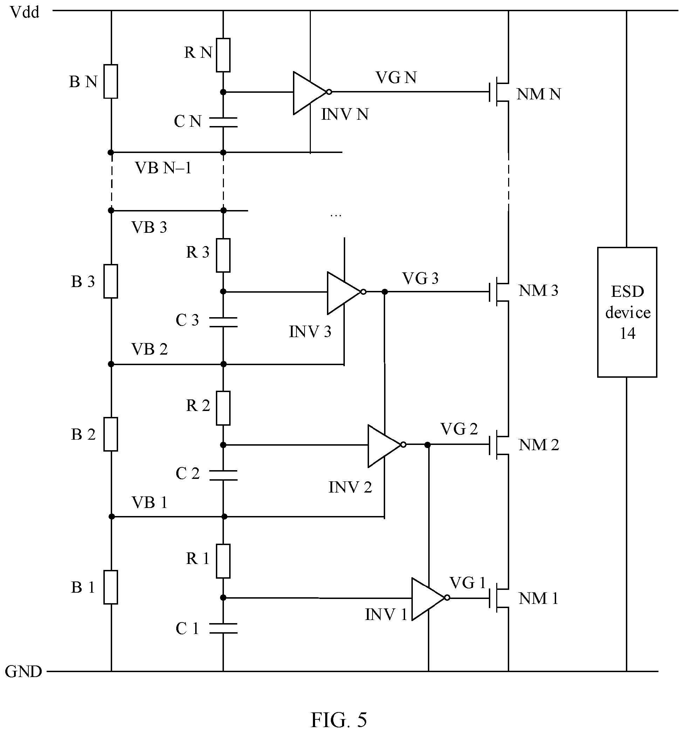

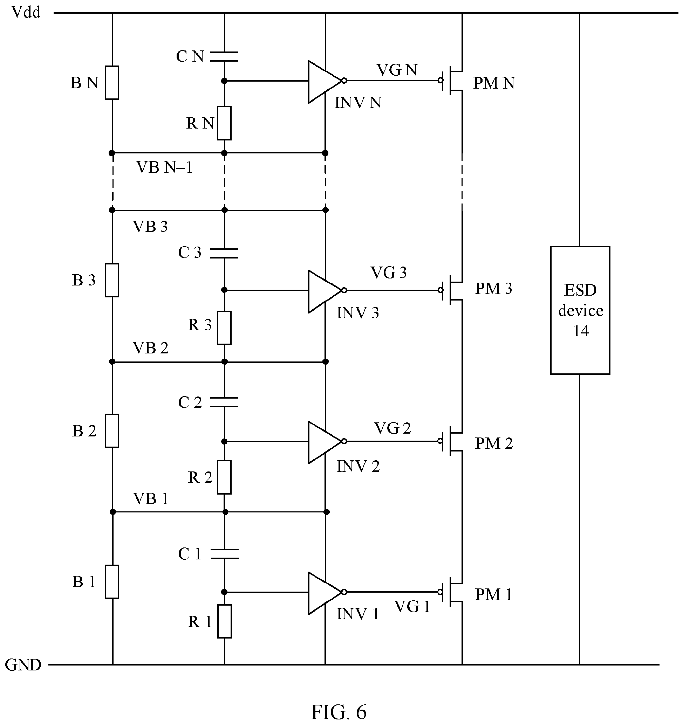

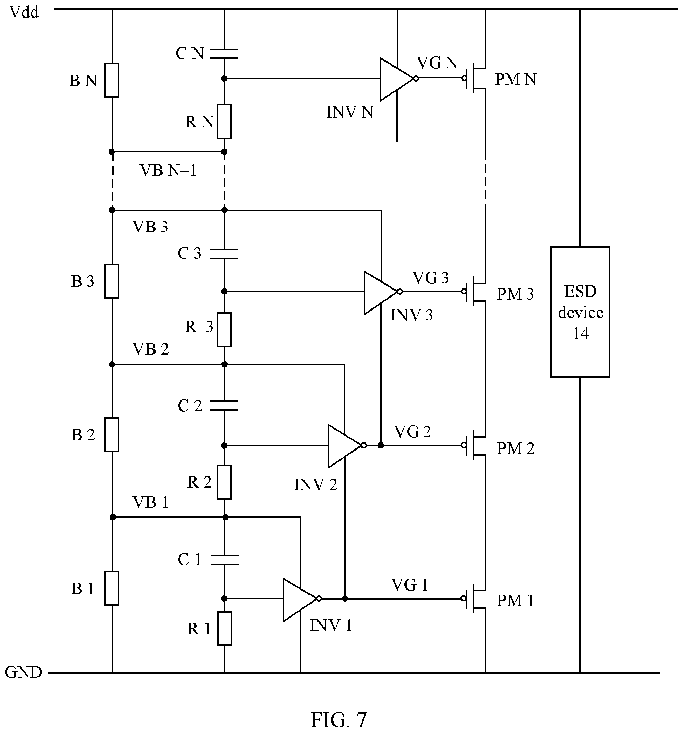

In a possible embodiment, as shown in FIG. 4 to FIG. 7, in each trigger circuit 12, the detection circuit includes a first resistor and a capacitor, the drive circuit includes an inverter, and a first end of the first resistor is coupled to a first node; a second end of the first resistor, a first end of the capacitor, and an input end of the inverter are coupled to each other; and a second end of the capacitor is coupled to a second node, the first node and the second node are two input ends of the trigger circuit 12, and an output end of the inverter is an output end of the trigger circuit. In FIG. 4, first resistors and capacitors in detection circuits in the plurality of trigger circuits 12 are respectively represented as an R 1 to an R N and a C 1 to a C N, and inverters in drive circuits in the plurality of trigger circuits 12 are represented as an INV 1 to an INV N. In FIG. 4 and FIG. 5, the plurality of MOS transistors 13 are represented as an NM 1 to an NM N. In FIG. 6 and FIG. 7, the plurality of MOS transistors 13 are represented as a PM 1 to a PM N.

In the ESD protection circuit, when the plurality of trigger circuits 12 are connected in series and coupled, the first node and the second node of each trigger circuit 12 may be connected in series and coupled, or one of the first node and the second node of each trigger circuit 12 and an output end of the trigger circuit 12 may be connected in series and coupled. The following uses an example for description.

In a possible example, as shown in FIG. 4 and FIG. 6, a first voltage end of an inverter of an N^{th} trigger circuit 12 in the plurality of trigger circuits 12 is coupled to the power line Vdd, a second voltage end of an inverter of a 1^{st} trigger circuit 12 is coupled to the ground line GND, and a first voltage end of an inverter of an (i-1)^{th} trigger circuit 12 is coupled to a second voltage end of an inverter of an i^{th} trigger circuit 12, where N is a quantity of the plurality of trigger circuits 12, and a value of i ranges from 2 to N.

In another possible example, as shown in FIG. 5, a first voltage end of an inverter of an N^{th} trigger circuit 12 in the plurality of trigger circuits 12 is coupled to the power line Vdd, a second voltage end of an inverter of a 1^{st} trigger circuit is coupled to the ground line GND, a first voltage end of an inverter of an (i-1)^{th} trigger circuit 12 is coupled to an output end of an i^{th} trigger circuit 12, and a second voltage end of an inverter of the i^{th} trigger circuit 12 is coupled to a second node of the i^{th} trigger circuit 12, where a value of i ranges from 2 to N.

In another possible example, as shown in FIG. 7, a first voltage end of an inverter of an N^{th} trigger circuit 12 in the plurality of trigger circuits 12 is coupled to the power line Vdd, a second voltage end of an inverter of a 1^{st} trigger circuit is coupled to the ground line GND, a second voltage end of an inverter of an i^{th} trigger circuit 12 is coupled to an output end of an (i-1)^{th} trigger circuit 12, and a first voltage end of the inverter of the i^{th} trigger circuit 12 is coupled to a second node of the i^{th} trigger circuit 12, where a value of i ranges from 2 to N.

Optionally, the first resistors R 1 to R N in the plurality of trigger circuits 12 may be implemented by using resistors in a semiconductor process, and the capacitors C 1 to C N may be implemented by using capacitors in the semiconductor process. The capacitor may be a MOS capacitor, a MOM capacitor, a MIM capacitor, a capacitor of another structure that can be implemented in the semiconductor process, or the like.

Further, as shown in FIG. 4 to FIG. 7, the plurality of bias circuits 11 include a plurality of second resistors, and the plurality of second resistors may be represented as a B 1 to a B N; and/or the plurality of MOS transistors 13 include a plurality of NMOS transistors or a plurality of PMOS transistors; and/or the ESD device 14 is a junction diode, a triode, or the like. In FIG. 4 and FIG. 5, an example in which the plurality of MOS transistors 13 include a plurality of NMOS transistors is used for description. In FIG. 6 and FIG. 7, an example in which the plurality of MOS transistors include a plurality of PMOS transistors is used for description.

Optionally, the plurality of second resistors B 1 to B N may be implemented by using resistors in the semiconductor process, the plurality of MOS transistors may also be implemented by using MOS transistors in the semiconductor process, and the ESD device 14 may also be implemented by using a junction diode or a triode in the semiconductor process. For example, the junction diode may be an N+/PWELL or NWELL/PWELL junction diode.

In an example, when the plurality of MOS transistors 13 include a plurality of NMOS transistors, the plurality of MOS transistors may be implemented by using N-type transistors in the semiconductor process, and substrates of the plurality of NMOS transistors may be directly coupled to the ground line GND, or substrates of the plurality of NMOS transistors are short-circuited to respective sources. In addition, when the substrates of the plurality of NMOS transistors are short-circuited to the respective sources, the plurality of NMOS transistors may be placed in a P well.

In another example, when the plurality of MOS transistors 13 include a plurality of PMOS transistors, the plurality of MOS transistors may be implemented by using P-type transistors in the semiconductor process, and substrates of the plurality of PMOS transistors may be directly coupled to the power line Vdd, or substrates of the plurality of PMOS transistors are short-circuited to respective sources. In addition, when the substrates of the plurality of PMOS transistors are short-circuited to the respective sources, the plurality of NMOS transistors may be placed in an N well.

In embodiments of this application, the plurality of bias circuits 11, the plurality of trigger circuits 12, and the plurality of MOS transistors 13 included in the ESD protection circuit are respectively connected in series and coupled between the power line Vdd and the ground line GND, and the withstand voltage of the ESD device 14, the sum of the withstand voltages of the plurality of bias circuits 11, the sum of the withstand voltages of the plurality of trigger circuits 12, and the sum of withstand voltages of the plurality of MOS transistors 13 are all greater than or equal to the power voltage between the power line Vdd and the ground line GND, so that the power voltage provided by the power line Vdd can be dispersedly borne by the plurality of bias circuits 11, the plurality of trigger circuits 12, and the plurality of MOS transistors 13. In this way, a voltage drop borne by each device in the plurality of bias circuits 11, the plurality of trigger circuits 12, and the plurality of MOS transistors 13 is only a part of the power voltage. This ensures that voltage drops borne by the ESD device 14, each bias circuit 11, each trigger circuit 12, and each MOS transistor 13 are respectively within ranges of the withstand voltages of the ESD device 14, each bias circuit 11, each trigger circuit 12, and each MOS transistor 13, and improves reliability of each device, thereby improving reliability of the ESD protection circuit, and ensuring a service life and performance of the integrated circuit.

An embodiment of this application further provides an ESD protection circuit. The ESD protection circuit includes a plurality of bias circuits 11 that are coupled between a power line Vdd and a ground line GND and that are connected in series, a plurality of trigger circuits 12 that are coupled between the power line Vdd and the ground line GND and that are connected in series, a plurality of MOS transistors 13 that are coupled between the power line Vdd and the ground line GND and that are connected in series, and an ESD device 14 coupled between the power line Vdd and the ground line GND. Output ends of the plurality of bias circuits 11 each are coupled to one input end of each of the plurality of trigger circuits 12, and output ends of the plurality of trigger circuits 12 are respectively coupled to control ends of the plurality of MOS transistors 13.

A withstand voltage of the ESD device 14, a sum of withstand voltages of the plurality of bias circuits 11, a sum of withstand voltages of the plurality of trigger circuits 12, and a sum of withstand voltages of the plurality of MOS transistors 13 are all greater than or equal to a power voltage between the power line Vdd and the ground line GND. Optionally, the withstand voltage of the ESD device 14 is greater than the withstand voltage of the bias circuit 11, the withstand voltage of the trigger circuit 12, or the withstand voltage of the MOS transistor 13. In a possible example, the withstand voltage of the ESD device 14 is N times the withstand voltage of the bias circuit 11, the withstand voltage of the trigger circuit 12, or the withstand voltage of the MOS transistor 13, where N is greater than 1.

In the ESD protection circuit, the plurality of bias circuits 11 are configured to provide plurality of different bias voltages, the plurality of trigger circuits 12 are configured to provide a plurality of drive voltages based on the plurality of different bias voltages, the plurality of MOS transistors 13 are configured to respectively receive the plurality of drive voltages, the plurality of drive circuits may be used for turning on the plurality of MOS transistors 13, and the ESD device is configured to discharge static electricity in the integrated circuit when the plurality of MOS transistors 13 are turned on. In this way, when static electricity is generated in the integrated circuit, the ESD protection circuit may discharge the static electricity, to prevent the protected device 20 in the integrated circuit from being affected by the static electricity.

It may be understood that, for detailed description of the ESD protection circuit, refer to the related description of the integrated circuit provided above. That is, for content of embodiments of the integrated circuit, refer to the embodiment of the ESD protection circuit. In embodiments of this application, details are not described herein again.

Based on this, an embodiment of this application further provides an electronic device. The electronic device includes a circuit board and any integrated circuit provided above. The integrated circuit is disposed on the circuit board. For example, the integrated circuit may be an integrated circuit corresponding to a processor or memory of the electronic device. Optionally, the circuit board may be a printed circuit board (printed circuit board, PCB), and the integrated circuit further includes a package substrate. The package substrate is fastened on the printed circuit board PCB by using a solder ball, and the integrated circuit is fastened on the package substrate by using the solder ball.

The electronic device may be used as a terminal device, or may be used as a server. Optionally, the electronic device includes but is not limited to a mobile phone, a tablet computer, a notebook computer, a desktop computer, a palmtop computer, an ultra-mobile personal computer (ultra-mobile personal computer, UMPC), a mobile internet device (mobile internet device, MID), a netbook, a video camera, a camera, a wearable device (such as a smart watch or a smart band), a vehicle-mounted device (such as a car, a bicycle, an electric vehicle, an airplane, a ship, a train, or a high-speed railway), a virtual reality (virtual reality, VR) device, an augmented reality (augmented reality, AR) device, a wireless terminal in industrial control (industrial control), a smart home device (such as a refrigerator, a television, an air conditioner, and an electric meter), a smart robot, a workshop device, a wireless terminal in self-driving (self-driving), a wireless terminal in remote medical surgery (remote medical surgery), a wireless terminal in smart grid (smart grid), a wireless terminal in transportation safety (transportation safety), a wireless terminal in smart city (smart city), a wireless terminal in smart home (smart home), a flight device (for example, a smart robot, a hot air balloon, an unmanned aerial vehicle, or an airplane), or the like.

It should be noted that the related description of the integrated circuit provided above may be referred to the electronic device, and details are not described herein in embodiments of this application.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An integrated circuit, wherein the integrated circuit comprises a power line, a ground line, at least one electrostatic discharge ESD protection circuit, and a protected device, and the protected device is disposed between the power line and the ground line;
the ESD protection circuit comprises a plurality of bias circuits that are coupled between the power line and the ground line and that are connected in series, a plurality of trigger circuits that are coupled between the power line and the ground line and that are connected in series, a plurality of MOS transistors that are coupled between the power line and the ground line and that are connected in series, and an ESD device coupled between the power line and the ground line, output ends of the plurality of bias circuits are respectively coupled to input ends of the plurality of trigger circuits, and output ends of the plurality of trigger circuits are respectively coupled to control ends of the plurality of MOS transistors;
a withstand voltage of the ESD device, a sum of withstand voltages of the plurality of bias circuits, a sum of withstand voltages of the plurality of trigger circuits, and a sum of withstand voltages of the plurality of MOS transistors are all greater than or equal to a power voltage between the power line and the ground line;
the plurality of bias circuits are configured to provide a plurality of different bias voltages;
the plurality of trigger circuits are configured to provide a plurality of drive voltages based on the plurality of different bias voltages; and
the plurality of MOS transistors are configured to respectively receive the plurality of drive voltages.

2. The integrated circuit according to claim 1, wherein each of the plurality of trigger circuits comprises:
a detection circuit, configured to detect an ESD current or an ESD voltage under an action of a bias voltage corresponding to the trigger circuit; and
a drive circuit, configured to provide the drive voltage when the ESD current or the ESD voltage is detected.

3. The integrated circuit according to claim 2, wherein the detection circuit comprises a first resistor and a capacitor, the drive circuit comprises an inverter, and a first end of the first resistor is coupled to a first node; a second end of the first resistor, a first end of the capacitor, and an input end of the inverter are coupled to each other; and a second end of the capacitor is coupled to a second node, the first node and the second node are two input ends of the trigger circuit, and an output end of the inverter is an output end of the trigger circuit.

4. The integrated circuit according to claim 3, wherein a first voltage end of an inverter of an N^{th} trigger circuit in the plurality of trigger circuits is coupled to the power line, a second voltage end of an inverter of a 1^{st} trigger circuit is coupled to the ground line, and a first voltage end of an inverter of an (i-1)^{th} trigger circuit is coupled to a second voltage end of an inverter of an i^{th} trigger circuit, wherein N is a quantity of the plurality of trigger circuits, and a value of i ranges from 2 to N.

5. The integrated circuit according to claim 3, wherein a first voltage end of an inverter of an N^{th} trigger circuit in the plurality of trigger circuits is coupled to the power line, and a second voltage end of an inverter of a 1^{st} trigger circuit is coupled to the ground line; and a first voltage end of an inverter of an (i-1)^{th} trigger circuit is coupled to an output end of an i^{th} trigger circuit, and a second voltage end of an inverter of the i^{th} trigger circuit is coupled to a second node of the i^{th} trigger circuit; or a second voltage end of an inverter of an i^{th} trigger circuit is coupled to an output end of an (i-1)^{th} trigger circuit, and a first voltage end of the inverter of the i^{th} trigger circuit is coupled to a second node of the i^{th} trigger circuit, wherein N is a quantity of the plurality of trigger circuits, and a value of i ranges from 2 to N.

6. The integrated circuit according to any one of claims 1 to 5, wherein the plurality of MOS transistors comprise a plurality of NMOS transistors or a plurality of PMOS transistors.

7. The integrated circuit according to any one of claims 1 to 6, wherein the plurality of bias circuits comprise a plurality of second resistors.

8. The integrated circuit according to any one of claims 1 to 7, wherein the ESD device is a junction diode.

9. The integrated circuit according to any one of claims 1 to 8, wherein the withstand voltage of the ESD device is N times the withstand voltage of the bias circuit, the withstand voltage of the trigger circuit, or the withstand voltage of the MOS transistor, wherein N is greater than 1.

10. An electronic device, wherein the electronic device comprises a circuit board and the integrated circuit, according to any one of claims 1 to 9, that is disposed on the circuit board.
